# EUROPEAN PATENT SPECIFICATION

(11) **EP 4 284 132 B1**
(45) Date of publication and mention of the grant of the patent: **11.11.2026**
(21) Application number: 22190308.1
(22) Date of filing: 12.08.2022
(51) Int. Cl.: H05K 7/20

(54) **IMMERSION COOLING SYSTEM AND COOLING METHOD THEREOF**
TAUCHKÜHLSYSTEM UND KÜHLVERFAHREN DAFÜR
SYSTÈME DE REFROIDISSEMENT PAR IMMERSION ET SON PROCÉDÉ DE REFROIDISSEMENT

(30) Priority: 24.05.2022 CN 202210574852
(43) Date of publication of application: 29.11.2023
(73) Proprietor: Delta Electronics, Inc., Taoyuan City 33370 (TW)
(72) Inventor: Chen, Li-Hsiu, 32063 Taoyuan City (TW); Yang, Ming-Tang, Taoyuan City (TW); Lin, Wei-Chih, Taoyuan City (TW); Chen, Peng-Yuan, Taoyuan City (TW); Wu, Sheng-Chi, Taoyuan City (TW); Chang, Ren-Chun, Taoyuan City (TW); Tsai, Wen-Yin, Taoyuan City (TW)
(74) Representative: Uexküll & Stolberg

(56) References cited:
- DE-A1- 102016 219 810
- US-A1- 2015 070 846
- US-A1- 2018 020 570
- US-A1- 2019 159 360
- US-A1- 2020 158 443

## Description

### FIELD OF THE INVENTION

The present disclosure relates to a cooling system and a cooling method thereof, and more particularly to an immersion cooling system and a cooling method thereof.

### BACKGROUND OF THE INVENTION

With the rapid development of 5th Generation mobile networks (5G), artificial intelligence, metaverse and other technologies that require high-speed computing, the requirements for heat dissipation of electronic components are getting higher. In addition, the consumed energy during the heat dissipation process is also emphasized.

One of the conventional ways to dissipate heat from the electronic components is to utilize the high-speed rotation of the fan to generate air convection, so as to remove the heat energy generated by the electronic components. However, the heat dissipation method that utilizes air convection to remove hot air cannot save energy, and also creates huge sound pollution. On the other hand, if the electronic components are immersed in the cooling liquid for cooling, the cooling liquid is evaporated into vapor so as to remove the heat energy generated by the electronic components, then the vapor will be condensed back to the cooling liquid according to the condensation technology. Under such circumstance, a water pump or valve should be added to control the liquid flow between the condensed cooling liquid and the cooling liquid soaking electronic components.

US 2015/070846 A1 describes an immersion cooling tank comprising a dielectric liquid disposed within a lower volume of the tank; at least one electronic equipment immersed within the dielectric liquid and which requires electrical power to operate; and at least one power distribution unit and/or a bus bar distribution system submerged beneath a surface of the dielectric liquid and providing electrical power to the at least one electronic equipment. The immersion cooling tank further includes a condenser located vertically above the dielectric fluid and the at least one electronic equipment, and through which is flowing a condensation fluid that has a lower density than the dielectric liquid. A leak of the condensation fluid into the tank volume results in the condensation fluid floating atop the dielectric liquid and prevents the condensation liquid from coming into contact with the power distribution unit. The bus bar distribution system enables blind mating of inserted electronic components.

US 2019/159360 A1 describes a very similar cooling device.

US 2020/158443 A1 relates to a cooling device which includes a sink, a first tube, a second tube, a heat exchanger, a pressure adjuster, and a dielectric liquid. The sink has a first outlet and a second outlet. The first tube has a first outlet connected to the first outlet of the sink, and a second outlet. The second tube has a first outlet connected to the second outlet of the sink, and a second outlet. The heat exchanger has a first outlet connected to the second outlet of the first tube, a second outlet connected to the second outlet of the second tube, and a third outlet. The pressure adjuster has an outlet connected to the third outlet of the heat exchanger. A heating element is placed in the sink and immersed in the dielectric liquid. The size of the pressure adjuster is defined by a volume of a vaporization status of the dielectric liquid.

Therefore, there is a need of providing an immersion cooling system and a cooling method thereof to obviate the drawbacks encountered from the prior arts.

### SUMMARY OF THE INVENTION

It is an objective of the present disclosure to provide an immersion cooling system and a cooling method thereof. The cooling liquid in the server box and the cooling liquid in the storage part are merged together through the liquid connecting pipe to maintain the same liquid level. Thereby, the cooling liquid condensed in the storage part can naturally flow back to the server box, and no water pump or valve should be added for controlling the flow of the cooling liquid.

In accordance with an aspect of the present disclosure, an immersion cooling system for a server cabinet according to claim 1 is provided. The immersion cooling system includes a plurality of server boxes, a cooling tank and a plurality of liquid connecting pipes. Each of the plurality of server boxes has a cooling liquid, and each of the plurality of server boxes includes an electronic device immersed in the cooling liquid, the electronic device of at least one of the plurality of server boxes generates a thermal energy during the operation of the electronic device so that a part of the cooling liquid evaporates into a hot vapor. The cooling tank is connected to the plurality of server boxes and includes a condenser and a storage part. The condenser is connected to a vent hole of each of the plurality of server boxes, wherein the condenser is configured to condense the hot vapor from the server box to form the cooling liquid. The storage part is connected to the condenser, wherein the storage part is configured to store the cooling liquid from the condenser, wherein the condenser and the storage part are disposed in the cooling tank. A first end of each of the plurality of liquid connecting pipes is connected to a bottom portion of the storage part, and a second end of each of the plurality of liquid connecting pipes is connected to a bottom portion of the corresponding server box. The cooling liquid in the storage part flows into each of the plurality of server boxes through each of the plurality of liquid connecting pipes. The cooling liquid in the storage part merges with the cooling liquid in each of the plurality of server boxes through the plurality of liquid connecting pipes to maintain a same liquid level.

In accordance with an aspect of the present disclosure, a cooling method of the immersion cooling system according to claim 8 is provided. The cooling method of the immersion cooling system includes steps of: providing a cooling liquid, a plurality of server boxes, a cooling tank and a plurality of liquid connecting pipes, wherein a part of the cooling liquid is contained in the plurality of server boxes, and the other part of the cooling liquid is contained in the cooling tank, the cooling tank is connected to the plurality of server boxes and the plurality of liquid connecting pipes; immersing a plurality of electronic devices in the cooling liquid in the corresponding server boxes, wherein each of the plurality of server boxes further includes a vapor space disposed above the cooling liquid, and the vapor space of each of the plurality of server boxes is connected to the cooling tank; operating the electronic device of at least one of the plurality of server boxes, wherein the electronic device of at least one of the plurality of server boxes generates a thermal energy during operation, which causes a part of the cooling liquid evaporates into hot vapor, and the hot vapor flows into the vapor space; utilizing a condenser of the cooling tank to condense the hot vapor from the server box to form the cooling liquid, wherein the cooling liquid flows into a storage part of the cooling tank through a plurality of copper pipes of the condenser; and utilizing the plurality of liquid connecting pipes to connect a bottom portion of the storage part and a bottom portion of each of the plurality of server boxes, and the cooling liquid in the storage part flowing into each of the plurality of server boxes through each of the plurality of liquid connecting pipes, wherein the cooling liquid in the storage part merges with the cooling liquid in each of the plurality of server boxes through the plurality of connecting pipes to maintain same liquid level, wherein the condenser and the storage part are disposed in the cooling tank.

The above contents of the present invention will become more readily apparent to those ordinarily skilled in the art after reviewing the following detailed description and accompanying drawings, in which:

### BRIEF DESCRIPTION OF THE DRAWINGS

FIG. 1 is a schematic block diagram illustrating an immersion cooling system according to an embodiment of the present disclosure;
FIG. 2 is a side view illustrating an immersion cooling system used in a server cabinet according to another embodiment of the present disclosure;
FIG. 3 is a schematic perspective view illustrating the condenser of the immersion cooling system of FIG. 2; and
FIG. 4 is a schematic flow chart illustrating a cooling method of the immersion cooling system according to an embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

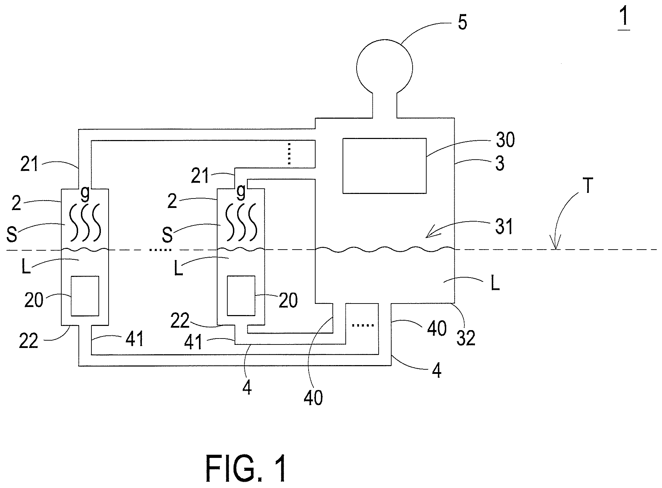

FIG. 1 is a schematic block diagram illustrating an immersion cooling system according to an embodiment of the present disclosure. As shown in FIG. 1, an immersion cooling system 1 includes a cooling liquid L, a plurality of server boxes 2, a cooling tank 3 and a plurality of liquid connecting pipes 4. A part of the cooling liquid L is contained in the plurality of server boxes 2, and the other part of the cooling liquid L is contained in the cooling tank 3. Each of the plurality of server boxes 2 includes an electronic device 20. The electronic device 20 is immersed in the cooling liquid L in the server box 2. A vapor space S is formed in each of the plurality of server boxes 2 above the cooling liquid L, and the vapor space S of each of the plurality of server boxes 2 is connected to the cooling tank 3. The electronic device 20 of at least one of the plurality of server boxes 2 generates thermal energy during operation, which causes part of the cooling liquid L evaporates into hot vapor g flowing into the vapor space S. The electronic device 20 is for example but not limited to a server. It should be noted that each server box 2 is a pressure-sealed box that avoids leakage of the hot vapor g. In an embodiment, the cooling liquid L is a non-conductive liquid with a boiling point between 50°C and 60°C. Each server box 2 further includes a vent hole 21, the vent hole 21 is connected to the cooling tank 3 and is configured to allow the hot vapor g to flow to the cooling tank 3 through the vent hole 21. The cooling tank 3 includes a condenser 30 and a storage part 31. The condenser 30 condenses the hot vapor g from the server box 2 to form the cooling liquid L. The storage part 31 is connected to the condenser 30, and the storage part 31 storages the cooling liquid L from the condenser 30. The storage part 31 has a bottom portion 32, and each server box 2 has a bottom portion 22. Each of the liquid connecting pipes 4 has a first end 40 and a second end 41. The first end 40 of each of the liquid connecting pipe 4 is connected to the bottom portion 32 of the storage part 31. The second end 41 of each of the liquid connecting pipe 4 is connected to the bottom portion 22 of the corresponding server box 2. The bottom portion 32 of the storage part 31 is higher than the bottom portion 22 of every server box 20 relative to the ground, so the cooling liquid L in the storage part 31 flows into the server boxes 2 through the liquid connecting pipes 4. The cooling liquid L in the storage part 31 merges with the cooling liquid L in each of the plurality of server boxes 2 through the plurality of liquid connecting pipes 4 to maintain the same liquid level T. It should be noted that the liquid level T in the present disclosure is the measured level of the cooling liquid L in the server box 2 and the storage part 31, namely the liquid level T may have a measurement error range. Consequently, the cooling liquid condensed in the storage part can naturally flow back to the server box, and no water pump or valve should be added for controlling the flow of the cooling liquid.

In an embodiment, the immersion cooling system 1 further includes a pressure balancing device 5. The pressure balancing device 5 is connected to the cooling tank 3, and is configured to balance the pressure in the cooling tank 3. The pressure balancing device 5 may include an inflatable or deflated means such as a balloon or a bellow, but not limited thereto. In an embodiment, the air pressure balancing device 5 adjusts the air pressure in the cooling tank 3 through inflation or deflation of the balloon or the bellow. For example, when the rate of generating the hot vapor g by the server box 2 is too high, the condenser 30 of the cooling tank 3 cannot condense the hot vapor g in time, such that the hot vapor g is accumulated in the cooling tank 3, resulting in excessive air pressure in the cooling tank 3. Under such circumstance, in the pressure balancing device 5, the air pressure in the cooling tank 3 can be adjusted through the inflation of the balloon or the bellow, so as to prevent the cooling tank 3 from being deformed and damaged.

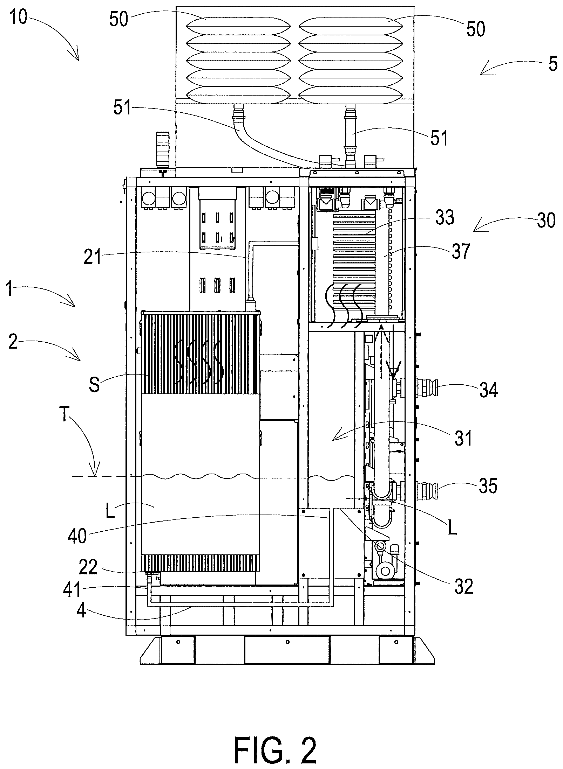

In an embodiment, the immersion cooling system 1 shown in FIG. 1 can be further used in a server cabinet. As shown in FIG. 2, FIG. 2 is a side view illustrating the immersion cooling system used in a server cabinet according to another embodiment of the present disclosure. In this embodiment, the immersion cooling system 1 is used in a server cabinet 10, and the air pressure balancing device 5 of the immersion cooling system 1 includes a bellow 50 and a connecting pipe 51 connected thereto. In an embodiment, an amount of the bellow 50 is not limited to one, and an amount of the corresponding connecting pipe 51 is not limited to one, either. The connecting pipe 51 is connected to the cooling tank 3. When the air pressure in the cooling tank 3 is too high, in the air pressure balancing device 5, part of the hot vapor g in the cooling tank 3 flows into the bellow 50 through the connecting pipe 51 to be absorbed by the inflatable bellow 50, thereby adjusting the air pressure in the cooling tank 3.

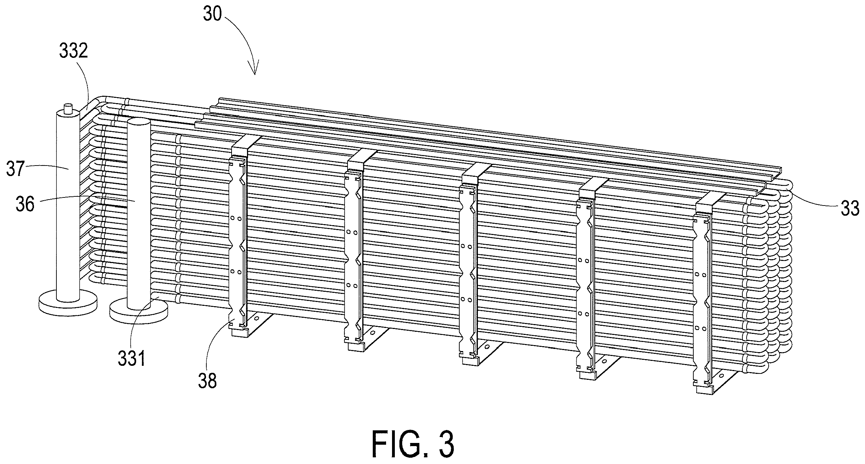

Please refer to FIGs. 2 and 3. FIG. 3 is a schematic perspective view illustrating the condenser of the immersion cooling system of FIG. 2. In this embodiment, the condenser 30 includes a first condensing pipe 36, a second condensing pipe 37, a plurality of copper pipes 33 which are bent and wound, a hot water output pipe 34 and a cooling water input pipe 35. The first condensing pipe 36 is connected to a first end 331 of each of the plurality of copper pipes 33. The second condensing pipe 37 is connected to a second end 332 of each of the plurality of copper pipes 33. The first condensing pipe 36 and the second condensing pipe 37 are connected to the hot water output pipe 34 and the cooling water input pipe 35, respectively. In addition, the cooling water input pipe 35 is further connected to an external cooling tower (not shown), and the cooling tower supplies cooling water (or other condensed liquid) to the condenser 30 via the cooling water input pipe 35. The cooling water is injected into the second condensing pipe 37 through the cooling water input pipe 35 (as depicted by the dashed arrow in FIG. 2). The cooling water flows into the plurality of copper pipes 33 through the second condensing pipe 37, an outer wall of the copper pipe 33 is cooled down by the flowing cooling water. Accordingly, the hot vapor g from the server box 2 condenses into the cooling liquid L when the hot vapor g contacts the outer wall of the copper pipe 33. At the same time, the heat energy lost from the hot vapor g during the condensation process is conducted inside of the copper pipe 33 to heat up the cooling water and turn it into hot water. The hot water is vented through the first condensing pipe 36 and the hot water output pipe 34 (as depicted by the solid arrow in FIG. 2). In an embodiment, the condenser 3 further includes a plurality of mounting brackets 38 connected to the plurality of copper pipes 33. The mounting bracket 38 is configured to fix the condenser 3 in the cooling tank 3.

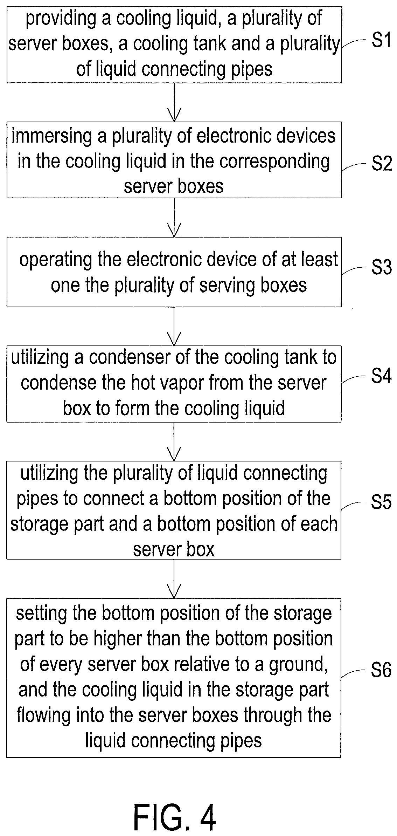

FIG. 4 is a schematic flow chart illustrating a cooling method of the immersion cooling system according to an embodiment of the present disclosure. The cooling method of the immersion cooling system of the present disclosure is applicable for the immersion cooling system 1 stated above. As shown in FIG. 4, the cooling method of the immersion cooling system includes steps S1, S2, S3, S4, S5 and S6. In the step S1, a cooling liquid L, a plurality of server boxes 2, a cooling tank 3 and a plurality of liquid connecting pipes 4 are provided. A part of the cooling liquid L is contained in the plurality of server boxes 2, and the other part of the cooling liquid L is contained in the cooling tank 3. The cooling tank 3 is connected to the plurality of server boxes 2 and the plurality of liquid connecting pipes 4. In the step S2, a plurality of electronic devices 20 are immersed in the cooling liquid L in the plurality of server boxes 2, respectively. A vapor space S is formed in each of the plurality of server boxes 2 above the cooling liquid L, and the vapor space S of each of the plurality of server boxes 2 is connected to the cooling tank 3. In the step S3, the electronic device 20 of at least one of the plurality of server boxes 2 is operated. The electronic device 20 of at least one of the plurality of server boxes 2 generates thermal energy during operation, which causes part of the cooling liquid L evaporates into hot vapor g flowing into the vapor space S. In the step S4, the condenser 30 of the cooling tank 3 condenses the hot vapor g from the server box 2 to form the cooling liquid L. The cooling liquid L flows into the storage part 31 of the cooling tank 3 through the plurality of copper pipes 33 of the condenser 30. In the step S5, the bottom portion 32 of the storage part 31 is connected to the bottom portion 22 of each server box 2 through the plurality of liquid connecting pipes 4. In the step S6, the bottom portion 32 of the storage part 31 is set to be higher than the bottom portion 22 of every server box 20 relative to the ground, so the cooling liquid L in the storage part 31 flows into the server boxes 2 through the liquid connecting pipes 4. The cooling liquid L in the storage part 31 merges with the cooling liquid L in each of the plurality of server boxes 2 through the plurality of liquid connecting pipes 4 to maintain the same liquid level T.

In an embodiment, the cooling method of the immersion cooling system of the present disclosure further includes a step of providing a pressure balancing device 5. The pressure balancing device 5 is connected to the cooling tank 3 and is configured to balance the pressure in the cooling tank 3.

In an embodiment, the cooling method of the immersion cooling system of the present disclosure further includes steps of: increasing an amount of the plurality of electronic devices 20 for increasing the hot vapor g being received by the condenser 30 and increasing the pressure in the cooling tank 3; and utilizing the pressure balancing device 5 connected to the cooling tank 3 to absorb the hot vapor g in the cooling tank 3 and to be inflated for maintaining the pressure in the cooling tank 3 within a constant pressure range.

In an embodiment, the cooling method of the immersion cooling system of the present disclosure further includes steps of: decreasing the amount of the plurality of electronic devices 20 for decreasing the hot vapor g being received by the condenser 30 and decreasing the pressure in the cooling tank 3; utilizing the pressure balancing device 5 to vent the vapor in the pressure balancing device 5 to the cooling tank 3 and to be deflated for maintaining the pressure in the cooling tank 3 within a constant pressure range.

From the above descriptions, the present disclosure provides an immersion cooling system and a cooling method thereof. The cooling liquid in the server box and the cooling liquid in the storage part are merged together through the liquid connecting pipe to maintain the same liquid level. Thereby, the cooling liquid condensed in the storage part can naturally flow back to the server box, and no water pump or valve should be added for controlling the flow of the cooling liquid.

## Claims

1. An immersion cooling system (1) for a server cabinet (10), comprising:
a plurality of server boxes (2), each having a cooling liquid (L) and comprising an electronic device (20) immersed in the cooling liquid (L), wherein the electronic device (20) of at least one of the plurality of server boxes (2) generates a thermal energy during the operation of the electronic device (20) so that a part of the cooling liquid (L) evaporates into a hot vapor (g);
a cooling tank (3) connected to the plurality of server boxes (2), and comprising:
a condenser (30) connected to a vent hole (21) of each of the plurality of server boxes (2), wherein the condenser (30) is configured to condense the hot vapor (g) from the server box (2) to form the cooling liquid (L); and
a storage part (31) connected to the condenser (30), wherein the storage part (31) is configured to store the cooling liquid (L) from the condenser (30); and
a plurality of liquid connecting pipes (4), each having a first end (40) connected to a bottom portion (32) of the storage part (31) and a second end (41) connected to a bottom portion (22) of the corresponding server box (2);
wherein the cooling liquid (L) in the storage part (31) flows into each of the plurality of server boxes (2) through each of the plurality of liquid connecting pipes (4),
wherein the cooling liquid (L) in the storage part (31) merges with the cooling liquid (L) in each of the plurality of server boxes (2) through the plurality of liquid connecting pipes (4) to maintain a same liquid level (T).

2. The immersion cooling system (1) according to claim 1, further comprising a pressure balancing device (5), wherein the pressure balancing device (5) is connected to the cooling tank (3) and is configured to balance the pressure in the cooling tank (3).

3. The immersion cooling system (1) according to claim 2, wherein the pressure balancing device (5) comprises a balloon or a bellow, and the balloon or the bellow regulates the pressure in the cooling tank (3) through inflation or deflation.

4. The immersion cooling system (1) according to claim 1, wherein the cooling liquid (L) is a non-conductive liquid with a boiling point between 50°C and 60°C.

5. The immersion cooling system (1) according to claim 1, wherein the condenser (30) comprises a first condensing pipe (36), a second condensing pipe (37), a plurality of copper pipes (33), a hot water output pipe (34) and a cooling water input pipe (35), each of the plurality of copper pipes (33) has a first end (331) and a second end (332), and each of the plurality of copper pipes (33) is bent and wound, the first condensing pipe (36) is connected to the first end (331) of each of the plurality of copper pipes (33), and the second condensing pipe (37) is connected to the second end (332) of each of the plurality of copper pipes (33), and the first condensing pipe (36) and the second condensing pipe (37) are connected to the hot water output pipe (34) and the cooling water input pipe (35), respectively.

6. The immersion cooling system (1) according to claim 5, wherein if a cooling water is injected into the second condensing pipe (37) through the cooling water input pipe (35), the cooling water flows into the plurality of copper pipes (33) through the second condensing pipe (37), an outer wall of the copper pipe (33) is cooled down by the flowing cooling water, the hot vapor (g) from the server box (2) condenses into the cooling liquid (L) when the hot vapor (g) contacts the outer wall of the copper pipe (33), wherein a heat energy lost from the hot vapor (g) during the condensation process is conducted inside of the copper pipe (33) to heat up the cooling water and turn it into a hot water, and the hot water is vented through the first condensing pipe (36) and the hot water output pipe (34).

7. The immersion cooling system (1) according to claim 1, wherein the bottom portion (32) of the storage part (31) is higher than the bottom portion (22) of each of the plurality of server boxes (2) relative to the ground so the cooling liquid (L) in the storage part (31) flows into each of the plurality of server boxes (2) through each of the plurality of liquid connecting pipes (4).

8. A cooling method of an immersion cooling system (1), comprising steps of:
providing a cooling liquid (L), a plurality of server boxes (2), a cooling tank (3) and a plurality of liquid connecting pipes (4), wherein a part of the cooling liquid (L) is contained in the plurality of server boxes (2), and the other part of the cooling liquid (L) is contained in the cooling tank (3), the cooling tank (3) is connected to the plurality of server boxes (2) and the plurality of liquid connecting pipes (4);
immersing a plurality of electronic devices (20) in the cooling liquid (L) in the plurality of server boxes (2), respectively, wherein a vapor space (S) is formed in each of the plurality of server boxes (2) above the cooling liquid (L), and the vapor space (S) of each of the plurality of server boxes (2) is connected to the cooling tank (3);
operating the electronic device (20) of at least one of the plurality of server boxes (2), wherein the electronic device (20) of at least one of the plurality of server boxes (2) generates a thermal energy during operation, which causes a part of the cooling liquid (L) evaporates into a hot vapor (g), and the hot vapor (g) flows into the vapor space (S);
utilizing a condenser (30) of the cooling tank (3) to condense the hot vapor (g) from the server box (2) to form the cooling liquid (L), wherein the cooling liquid (L) flows into a storage part (31) of the cooling tank (3) through a plurality of copper pipes (33) of the condenser (30); and
utilizing the plurality of liquid connecting pipes (4) to connect a bottom portion (32) of the storage part (31) and a bottom portion (22) of each of the plurality of server boxes (2), and the cooling liquid (L) in the storage part (31) flowing into each of the plurality server boxes (2) through each of the plurality of liquid connecting pipes (4), wherein each one of the plurality of liquid connecting pipes (4) has a first end (40) connected to the bottom portion (32) of the storage part (31) and a second end (41) connected to the bottom portion (22) of the corresponding server box (2),
wherein the cooling liquid (L) in the storage part (31) merges with the cooling liquid (L) in each of the plurality of server boxes (2) through the plurality of connecting pipes (4) to maintain a same liquid level (T).

9. The cooling method according to claim 8, further comprising a step of providing a pressure balancing device (5), wherein the pressure balancing device (5) is connected to the cooling tank (3) and is configured to balance the pressure in the cooling tank (3).

10. The cooling method according to claim 9, further comprising steps of:
increasing an amount of the plurality of electronic devices (20) for increasing the hot vapor (g) being received by the condenser (30) and increasing the pressure in the cooling tank (3); and
utilizing the pressure balancing device (5) connected to the cooling tank (3) to absorb the hot vapor (g) in the cooling tank (3) and to be inflated for maintaining the pressure in the cooling tank (3) within a constant pressure range.

11. The cooling method according to claim 10, further comprising steps of:
decreasing the amount of the plurality of electronic devices (20) for decreasing the hot vapor (g) being received by the condenser (30) and decreasing the pressure in the cooling tank (3); and
utilizing the pressure balancing device (5) to vent the vapor in the pressure balancing device (5) to the cooling tank (3) and to be deflated for maintaining the pressure in the cooling tank (3) within the constant pressure range.

12. The cooling method according to claim 8, further comprising a step of:
setting the bottom portion (32) of the storage part (31) to be higher than the bottom portion (22) of each of the plurality of server boxes (2) relative to a ground, and the cooling liquid (L) in the storage part (31) flowing into each of the plurality of server boxes (2) through each of the plurality of liquid connecting pipes (4).

## Patentansprüche

1. Tauchkühlsystem (1) für einen Serverschrank (10), umfassend:
eine Mehrzahl von Server-Boxen (2), die jeweils eine Kühlflüssigkeit (L) enthalten und eine elektronische Vorrichtung (20) aufweisen, die in die Kühlflüssigkeit (L) eingetaucht ist, wobei die elektronische Vorrichtung (20) von mindestens einer der Mehrzahl von Server-Boxen (2) während des Betriebs der elektronischen Vorrichtung (20) thermische Energie erzeugt, so dass ein Teil der Kühlflüssigkeit (L) zu heißem Dampf (g) verdampft;
einen Kühltank (3), der mit der Mehrzahl von Server-Boxen (2) verbunden ist, und umfassend:
einen Kondensator (30), der mit einer Entlüftungsloch (21) von jeder der Mehrzahl von Server-Boxen (2) verbunden ist, wobei der Kondensator (30) konfiguriert ist, um den heißen Dampf (g) aus der Server-Box (2) zu kondensieren, um die Kühlflüssigkeit (L) zu bilden; und
einen mit dem Kondensator (30) in Verbindung stehenden Speicherabschnitt (31), wobei der Speicherabschnitt (31) konfiguriert ist, um die Kühlflüssigkeit (L) von dem Kondensator (30) zu speichern; und
eine Mehrzahl von Flüssigkeitsverbindungsleitungen (4), die jeweils ein erstes Ende (40), das mit einem Bodenbereich (32) des Speicherabschnitts (31) verbunden ist, und ein zweites Ende (41) haben, das mit einem Bodenbereich (22) der zugehörigen Server-Box (2) verbunden ist;
wobei die Kühlflüssigkeit (L) in dem Speicherabschnitt (31) durch jede der Mehrzahl von Flüssigkeitsverbindungsleitungen (4) in jede der Mehrzahl von Server-Boxen (2) fließt,
wobei sich die Kühlflüssigkeit (L) in dem Speicherabschnitt (31) mit der Kühlflüssigkeit (L) in jeder der Mehrzahl von Server-Boxen (2) durch die Mehrzahl von Flüssigkeitsverbindungsleitungen (4) vermischt, um einen gleichen Flüssigkeitspegel (T) aufrechtzuerhalten.

2. Tauchkühlsystem (1) nach Anspruch 1, ferner umfassend eine Druckausgleichsvorrichtung (5), wobei die Druckausgleichsvorrichtung (5) mit dem Kühltank (3) verbunden und konfiguriert ist, um den Druck in dem Kühltank (3) auszugleichen.

3. Tauchkühlsystem (1) nach Anspruch 2, wobei die Druckausgleichsvorrichtung (5) einen Ballon oder einen Balg aufweist, und der Ballon oder der Balg den Druck in dem Kühltank (3) durch Aufblasen oder Abblasen reguliert.

4. Tauchkühlsystem (1) nach Anspruch 1, wobei die Kühlflüssigkeit (L) eine nichtleitende Flüssigkeit mit einem Siedepunkt zwischen 50°C und 60°C ist.

5. Tauchkühlsystem (1) nach Anspruch 1, wobei der Kondensator (30) eine erste Kondensatorleitung (36), eine zweite Kondensatorleitung (37), eine Mehrzahl von Kupferleitungen (33), eine Heißwasser-Auslassleitung (34) und ein Kühlwasser-Einlassleitung (35) umfasst, jede der Mehrzahl von Kupferleitungen (33) ein erstes Ende (331) und ein zweites Ende (332) hat, und jede der Mehrzahl von Kupferleitungen (33) gebogen und gewickelt ist, die erste Kondensatorleitung (36) mit dem ersten Ende (331) von jeder der Mehrzahl von Kupferleitungen (33) verbunden ist, und die zweite Kondensatorleitung (37) mit dem zweiten Ende (332) von jeder der Mehrzahl von Kupferleitungen (33) verbunden ist, und die erste Kondensatorleitung (36) und die zweite Kondensatorleitung (37) mit dem Heißwasser-Auslassleitung (34) bzw. der Kühlwasser-Einlassleitung (35) verbunden sind.

6. Tauchkühlsystem (1) nach Anspruch 5, wobei, wenn Kühlwasser durch die Kühlwasser-Einlassleitung (35) in die zweite Kondensatorleitung (37) eingeleitet wird, das Kühlwasser durch die zweite Kondensatorleitung (37) in die Mehrzahl von Kupferleitungen (33) fließt, eine Außenwand der Kupferleitung (33) durch das fließende Kühlwasser heruntergekühlt wird, der heiße Dampf (g) aus der Server-Box (2) zu Kühlflüssigkeit (L) kondensiert, wenn der heiße Dampf (g) mit der Außenwand der Kupferleitung (33) in Kontakt kommt, wobei die während des Kondensationsprozesses von dem heißen Dampf (g) abgegebene Wärmeenergie in das Innere der Kupferleitung (33) geleitet wird, um das Kühlwasser zu erwärmen und es in heißes Wasser umzuwandeln, und das heiße Wasser durch die erste Kondensatorleitung (36) und die Heißwasser-Auslassleitung (34) abgeleitet wird.

7. Tauchkühlsystem (1) nach Anspruch 1, wobei der Bodenbereich (32) des Speicherabschnitts (31) relativ zum Untergrund höher liegt als der Bodenbereich (22) von jeder der Mehrzahl von Server-Boxen (2), so dass die Kühlflüssigkeit (L) in dem Speicherabschnitt (31) durch jede der Mehrzahl von Flüssigkeitsverbindungsleitungen (4) in jede der Mehrzahl von Server-Boxen (2) fließt.

8. Kühlverfahren für ein Tauchkühlsystem (1), umfassend die Schritte:
Bereitstellen einer Kühlflüssigkeit (L), einer Mehrzahl von Server-Boxen (2), eines Kühltanks (3) und einer Mehrzahl von Flüssigkeitsverbindungsleitungen (4), wobei ein Teil der Kühlflüssigkeit (L) in der Mehrzahl von Server-Boxen (2) enthalten ist, und der andere Teil der Kühlflüssigkeit (L) in dem Kühltank (3) enthalten ist, wobei der Kühltank (3) mit der Mehrzahl von Server-Boxen (2) und der Mehrzahl von Flüssigkeitsverbindungsleitungen (4) verbunden ist;
Eintauchen einer Mehrzahl von elektronischen Vorrichtungen (20) in die Kühlflüssigkeit (L) der Mehrzahl von jeweiligen Server-Boxen (2), wobei ein Dampfraum (S) in jeder der Mehrzahl von Server-Boxen (2) oberhalb der Kühlflüssigkeit (L) gebildet ist, und der Dampfraum (S) von jeder der Mehrzahl von Server-Boxen (2) mit dem Kühltank (3) verbunden ist;
Betreiben der elektronischen Vorrichtung (20) von mindestens einer der Mehrzahl von Server-Boxen (2), wobei die elektronische Vorrichtung (20) von mindestens einer der Mehrzahl von Server-Boxen (2) während des Betriebs thermische Energie erzeugt, wodurch bewirkt wird, dass ein Teil der Kühlflüssigkeit (L) zu heißem Dampf (g) verdampft, und der heiße Dampf (g) in den Dampfraum (S) strömt;
Verwenden eines Kondensators (30) des Kühltanks (3), um den heißen Dampf (g) von der Server-Box (2) zu kondensieren, um die Kühlflüssigkeit (L) zu bilden, wobei die Kühlflüssigkeit (L) durch eine Mehrzahl von Kupferleitungen (33) des Kondensators (30) in einen Speicherabschnitt (31) des Kühltanks (3) fließt; und
Verwendung der Mehrzahl von Flüssigkeitsverbindungsleitungen (4), um einen Bodenbereich (32) des Speicherabschnitts (31) und einen Bodenbereich (22) von jeder der Mehrzahl von Server-Boxen (2) zu verbinden, und die Kühlflüssigkeit (L) in dem Speicherabschnitt (31) durch jede der Mehrzahl von Flüssigkeitsverbindungsleitungen (4) in jede der Mehrzahl von Server-Boxen (2) fließt, wobei jede der Mehrzahl von Flüssigkeitsverbindungsleitungen (4) ein erstes Ende (40), das mit dem Bodenbereich (32) des Speicherabschnitts (31) verbunden ist, und ein zweites Ende (41) hat, das mit dem Bodenbereich (22) der zugehörigen Server-Box (2) verbunden ist,
wobei die Kühlflüssigkeit (L) in dem Speicherabschnitt (31) mit der Kühlflüssigkeit (L) in jeder der Mehrzahl von Server-Boxen (2) durch die Mehrzahl von Verbindungsleitungen (4) vermischt wird, um einen gleichen Flüssigkeitspegel (T) aufrechtzuerhalten.

9. Kühlverfahren nach Anspruch 8, ferner umfassend einen Schritt des Bereitstellens einer Druckausgleichsvorrichtung (5), wobei die Druckausgleichsvorrichtung (5) mit dem Kühltank (3) verbunden und konfiguriert ist, um den Druck in dem Kühltank (3) auszugleichen.

10. Kühlverfahren nach Anspruch 9, ferner umfassend die Schritte:
Erhöhen einer Anzahl der Mehrzahl von elektronischen Vorrichtungen (20), um die Menge an heißem Dampf (g) zu erhöhen, der von dem Kondensator (30) aufgenommen wird, und den Druck in dem Kühltank (3) zu erhöhen; und
Verwenden der Druckausgleichsvorrichtung (5), die mit dem Kühltank (3) verbunden ist, um den heißen Dampf (g) in dem Kühltank (3) aufzunehmen und um aufgeblasen zu werden, um den Druck in dem Kühltank (3) innerhalb eines konstanten Druckbereichs zu halten.

11. Kühlverfahren nach Anspruch 10, ferner umfassend die Schritte:
Verringern der Anzahl der Mehrzahl von elektronischen Vorrichtungen (20), um die Menge an heißem Dampf (g) zu verringern, der von dem Kondensator (30) aufgenommen wird, und den Druck in dem Kühltank (3) zu verringern; und
Verwenden der Druckausgleichsvorrichtung (5), um den Dampf in der Druckausgleichsvorrichtung (5) in den Kühltank (3) abzulassen und um abgeblasen zu werden, um den Druck in dem Kühltank (3) innerhalb des konstanten Druckbereichs zu halten.

12. Kühlverfahren nach Anspruch 8, ferner umfassend einen Schritt:
Einstellen des Bodenbereichs (32) des Speicherabschnitts (31), um relativ zum Untergrund höher zu liegen als der Bodenbereich (22) von jeder der Mehrzahl von Server-Boxen (2), und die Kühlflüssigkeit (L) in dem Speicherabschnitt (31) durch jede der Mehrzahl von Flüssigkeitsverbindungsleitungen (4) in jede der Mehrzahl von Server-Boxen (2) fließt.

## Revendications

1. Système de refroidissement par immersion (1) pour armoire de serveur (10), comprenant:
une pluralité de boîtiers de serveur (2), chacun ayant un liquide de refroidissement (L) et comprenant un dispositif électronique (20) immergé dans le liquide de refroidissement (L), dans lequel le dispositif électronique (20) d'au moins l'un des boîtiers de serveur (2) génère une énergie thermique pendant le fonctionnement du dispositif électronique (20), de sorte qu'une partie du liquide de refroidissement (L) s'évapore en produisant une vapeur chaude (g);
une cuve de refroidissement (3) reliée à la pluralité de boîtiers de serveur (2), et comprenant:
un condenseur (30) relié à un évent (21) de chacun des boîtiers de serveur (2), le condenseur (30) étant configuré pour condenser la vapeur chaude (g) du boîtier de serveur (2) pour former le liquide de refroidissement (L); et
une partie de stockage (31) reliée au condenseur (30), la partie de stockage (31) étant configurée pour stocker le liquide de refroidissement (L) provenant du condenseur (30); et
une pluralité de tuyaux de connexion de liquide (4), chacun ayant une première extrémité (40) reliée à une partie inférieure (32) de la partie de stockage (31) et une deuxième extrémité (41) reliée à une partie inférieure (22) du boîtier de serveur correspondant (2);
dans lequel le liquide de refroidissement (L) présent dans la partie de stockage (31) circule dans chacun des boîtiers de serveur (2) en passant par chacun des tuyaux de connexion de liquide (4),
dans lequel le liquide de refroidissement (L) présent dans la partie de stockage (31) se joint au liquide de refroidissement (L) présent dans chacun des boîtiers de serveur (2) via la pluralité de tuyaux de connexion de liquide (4) pour maintenir un même niveau de liquide (T).

2. Système de refroidissement par immersion (1) selon la revendication 1, comprenant en outre un dispositif d'équilibrage de pression (5), dans lequel le dispositif d'équilibrage de pression (5) est relié à la cuve de refroidissement (3) et est configuré pour équilibrer la pression dans la cuve de refroidissement (3).

3. Système de refroidissement par immersion (1) selon la revendication 2, dans lequel le dispositif d'équilibrage de pression (5) comprend un ballon ou un soufflet, et le ballon ou le soufflet régule la pression dans la cuve de refroidissement (3) par gonflage ou dégonflage.

4. Système de refroidissement par immersion (1) selon la revendication 1, dans lequel le liquide de refroidissement (L) est un liquide non conducteur ayant un point d'ébullition compris entre 50 °C et 60 °C.

5. Système de refroidissement par immersion (1) selon la revendication 1, dans lequel le condenseur (30) comprend un premier tuyau de condensation (36), un deuxième tuyau de condensation (37), une pluralité de tuyaux de cuivre (33), un tuyau de sortie d'eau chaude (34) et un tuyau d'entrée d'eau de refroidissement (35), chacun des tuyaux de cuivre (33) a une première extrémité (331) et une deuxième extrémité (332), et chacun des tuyaux de cuivre (33) est courbé et enroulé, le premier tuyau de condensation (36) est relié à la première extrémité (331) de chacun des tuyaux de cuivre (33), et le deuxième tuyau de condensation (37) est relié à la deuxième extrémité (332) de chacun des tuyaux de cuivre (33), et le premier tuyau de condensation (36) et le deuxième tuyau de condensation (37) sont reliés respectivement au tuyau de sortie d'eau chaude (34) et au tuyau d'entrée d'eau de refroidissement (35).

6. Système de refroidissement par immersion (1) selon la revendication 5, dans lequel, si on injecte une eau de refroidissement dans le deuxième tuyau de condensation (37) par le tuyau d'entrée d'eau de refroidissement (35), l'eau de refroidissement entre dans la pluralité de tuyaux de cuivre (33) via le deuxième tuyau de condensation (37), une paroi extérieure du tuyau de cuivre (33) est refroidie par l'eau de refroidissement en circulation, la vapeur chaude (g) provenant du boîtier de serveur (2) se condense dans le liquide de refroidissement (L) lorsque la vapeur chaude (g) entre en contact avec la paroi extérieure du tuyau de cuivre (33), dans lequel une énergie thermique perdue par la vapeur chaude (g) pendant le processus de condensation est conduite à l'intérieur du tuyau de cuivre (33) pour réchauffer l'eau de refroidissement et la transformer en eau chaude, et l'eau chaude est dispersée dans le premier tuyau de condensation (36) et le tuyau de sortie d'eau chaude (34).

7. Système de refroidissement par immersion (1) selon la revendication 1, dans lequel la partie inférieure (32) de la partie de stockage (31) se trouve plus haut que la partie inférieure (22) de chacun des boîtiers de serveur (2) par rapport au sol, de sorte que le liquide de refroidissement (L) présent dans la partie de stockage (31) entre dans chacun des boîtiers de serveur (2) via chacun des tuyaux de connexion de liquide (4).

8. Procédé de refroidissement d'un système de refroidissement par immersion (1), comprenant les étapes suivantes:
fournir un liquide de refroidissement (L), une pluralité de boîtiers de serveur (2), une cuve de refroidissement (3) et une pluralité de tuyaux de connexion de liquide (4), dans lequel une partie du liquide de refroidissement (L) est contenue dans la pluralité de boîtiers de serveur (2) et l'autre partie du liquide de refroidissement (L) est contenue dans la cuve de refroidissement (3), la cuve de refroidissement (3) étant reliée à la pluralité de boîtiers de serveur (2) et à la pluralité de tuyaux de connexion de liquide (4);
immerger une pluralité de dispositifs électroniques (20) dans le liquide de refroidissement (L) dans la pluralité de boîtiers de serveur (2), respectivement, dans lequel un espace de vapeur (S) est formé dans chacun des boîtiers de serveur (2) au-dessus du liquide de refroidissement (L), et l'espace de vapeur (S) de chacun des boîtiers de serveur (2) est relié à la cuve de refroidissement (3);
faire fonctionner le dispositif électronique (20) d'au moins un boîtier de la pluralité de boîtiers de serveur (2), dans lequel le dispositif électronique (20) d'au moins un boîtier de la pluralité de boîtiers de serveur (2) génère une énergie thermique pendant son fonctionnement, ce qui provoque l'évaporation d'une partie du liquide de refroidissement (L) en une vapeur chaude (g), et la vapeur chaude (g) entre dans l'espace de vapeur (S);
utiliser un condenseur (30) de la cuve de refroidissement (3) pour condenser la vapeur chaude (g) provenant du boîtier de serveur (2) pour former le liquide de refroidissement (L), dans lequel le liquide de refroidissement (L) entre dans une partie de stockage (31) de la cuve de refroidissement (3) via une pluralité de tuyaux de cuivre (33) du condenseur (30); et
utiliser la pluralité de tuyaux de connexion de liquide (4) pour relier une partie inférieure (32) de la partie de stockage (31) et une partie inférieure (22) de chacun des boîtiers de serveur (2), et le liquide de refroidissement (L) présent dans la partie de stockage (31) entrant dans chacun des boîtiers de serveur (2) en passant par chacun des tuyaux de connexion de liquide (4), dans lequel chacun des tuyaux de connexion de liquide (4) a une première extrémité (40) reliée à la partie inférieure (32) de la partie de stockage (31) et une deuxième extrémité (41) reliée à la partie inférieure (22) du boîtier de serveur correspondant (2),
dans lequel le liquide de refroidissement (L) présent dans la partie de stockage (31) se joint au liquide de refroidissement (L) présent dans chacun des boîtiers de serveur (2) via la pluralité de tuyaux de connexion de liquide (4) pour maintenir un même niveau de liquide (T).

9. Procédé de refroidissement selon la revendication 8, comprenant en outre une étape consistant à fournir un dispositif d'équilibrage de pression (5), dans lequel le dispositif d'équilibrage de pression (5) est relié à la cuve de refroidissement (3) et est configuré pour équilibrer la pression dans la cuve de refroidissement (3).

10. Procédé de refroidissement selon la revendication 9, comprenant en outre les étapes suivantes:
augmenter une quantité de la pluralité de dispositifs électroniques (20) pour augmenter la vapeur chaude (g) qui est reçue par le condenseur (30) et pour augmenter la pression dans la cuve de refroidissement (3); et
utiliser le dispositif d'équilibrage de pression (5) relié à la cuve de refroidissement (3) pour absorber la vapeur chaude (g) dans la cuve de refroidissement (3) et pour qu'il soit gonflé pour maintenir la pression dans la cuve de refroidissement (3) dans une plage de pression constante.

11. Procédé de refroidissement selon la revendication 10, comprenant en outre les étapes suivantes:
réduire la quantité de la pluralité de dispositifs électroniques (20) pour réduire la vapeur chaude (g) qui est reçue par le condenseur (30) et pour réduire la pression dans la cuve de refroidissement (3); et
utiliser le dispositif d'équilibrage de pression (5) pour évacuer la vapeur présente dans le dispositif d'équilibrage de pression (5) vers la cuve de refroidissement (3) et pour qu'il soit dégonflé pour maintenir la pression dans la cuve de refroidissement (3) dans la plage de pression constante.

12. Procédé de refroidissement selon la revendication 8, comprenant en outre une étape consistant à régler la partie inférieure (32) de la partie de stockage (31) de manière à ce qu'elle se trouve plus haut que la partie inférieure (22) de chacun des boîtiers de serveur (2) par rapport au sol, et le liquide de refroidissement (L) présent dans la partie de stockage (31) entrant dans chacun des boîtiers de serveur (2) via chacun des tuyaux de connexion de liquide (4).
